# EUROPEAN PATENT SPECIFICATION

(11) **EP 3 719 859 B1**
(45) Date of publication and mention of the grant of the patent: **23.07.2025**
(21) Application number: 18859942.7
(22) Date of filing: 05.09.2018
(51) Int. Cl.: H10K 59/80, H10K 50/844

(54) **DISPLAY PANEL, PACKAGING METHOD THEREFOR, AND DISPLAY DEVICE**
ANZEIGETAFEL, VERPACKUNGSVERFAHREN DAFÜR UND ANZEIGEVORRICHTUNG
PANNEAU D'AFFICHAGE, SON PROCÉDÉ D'ENCAPSULATION ET DISPOSITIF D'AFFICHAGE

(30) Priority: 30.11.2017 CN 201711240035
(43) Date of publication of application: 07.10.2020
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: YANG, Xiaodong, Beijing 100176 (CN); LI, Duanming, Beijing 100176 (CN); SUN, Quanqin, Beijing 100176 (CN); ZHANG, Qin, Beijing 100176 (CN); ZHANG, Shuai, Beijing 100176 (CN)
(74) Representative: Isarpatent
(86) International application number: PCT/CN2018/104121
(87) International publication number: WO 2019/105091

(56) References cited:
- EP-A1- 2 747 164
- CN-A- 106 992 263
- CN-A- 107 302 014
- CN-A- 107 359 281
- CN-A- 107 394 058
- CN-U- 207 425 923
- US-A1- 2016 043 340
- US-A1- 2016 307 971
- US-A1- 2016 372 707
- US-A1- 2017 207 418

## Description

### TECHNICAL FIELD

The present disclosure relates to the field of display technology, in particular to a display panel and a method for packaging the same, and a display device comprising the display panel.

### BACKGROUND

The development trends of Organic Light-Emitting Diode (OLED) display screens are narrow bezel, low power consumption, bendability, foldability and the like. The package film layer of the existing flexible OLED package structure comprises an organic film and an inorganic film laminated in sequence. In manufacturing the organic film, the organic film is formed by inkjet printing a rheological organic material, such as an acrylic material, in a filled region surrounded by a barrier and then making the rheological organic material solidify in the filled region.

CN 107359281 A discloses a preparation method for an encapsulation assembly, an encapsulation assembly and a display device.

US 2016/043340 A1 discloses a display device that prevents adverse effects on pixel circuits, resulting from a process related to a sealing film, and a manufacturing method of the display device.

EP 2 747 164 A1 discloses an organic light emitting display apparatus which includes a substrate, a display unit on the substrate, and a thin-film encapsulation layer for sealing the display unit, the thin-film encapsulation layer including a first organic film, a first inorganic film covering the first organic film, and an interlayer disposed at a lower surface of the first organic film, the interlayer defining an area where the first organic film is formed, an area of the interlayer being the same as the area of the first organic film.

US 2017/207418A discloses a display device including a substrate which includes a display region and a peripheral region and a method of manufacturing the display device.

US 2016/307971A1 discloses an organic light emitting diode display including a substrate which includes a display area and a peripheral area surrounding the display area, an organic light emitting member disposed in the display area, dams disposed in the peripheal area, a thin film encapsulation layer covering a portion of a first dam among the dams and the organic light emitting member, a touch sensing member disposed on the thin film encapsulation layer of the display area, and a first crack sensing member disposed at a position corresponding to the first dam.

### SUMMARY

The present application provides a display panel, a display device and a method for packaging a display panel, as defined in the appended set of claims.

### BRIEF DESCRIPTION OF THE DRAWINGS

Fig. 1 is a schematic diagram of a related OLED display panel.
Fig. 2 is a schematic diagram of a display panel according to an embodiment of the present disclosure.
Fig. 3 is a schematic diagram of a display panel according to another embodiment of the present disclosure.

### DETAILED DESCRIPTION

In order to make the technical problems to be solved, the technical solutions, and the advantages of the embodiments of the present disclosure, the present disclosure will be described hereinafter in conjunction with the drawings and specific examples.

The development trends of OLED display screens are narrow bezel, low power consumption, bendability, foldability and the like. The packaging process of the related flexible OLED package structure mainly comprises: manufacturing a flexible substrate; manufacturing a first gate insulating layer; manufacturing a first gate metal layer pattern; manufacturing a second gate insulating layer; manufacturing a second gate metal layer pattern; manufacturing an interlayer insulating layer; manufacturing the source-drain metal layer pattern; manufacturing an overcoat; manufacturing an anode; manufacturing a pixel defining layer; manufacturing a spacer layer; manufacturing a cathode; manufacturing a package film layer. The package film layer comprises an organic film and an inorganic film laminated in sequence. In manufacturing the organic film, an organic film is formed by inkjet printing a rheological organic material, such as an acrylic material, in a filled region surrounded by a barrier and making the rheological organic material in the filled region solidifying.

In order to ensure the display quality of the OLED display screen, the package film layer needs to concern both the high water-oxygen barrier capacity and the uniformity of the organic film. However, the related package film layer cannot concern both the high water-oxygen barrier capacity and the uniformity of the organic film.

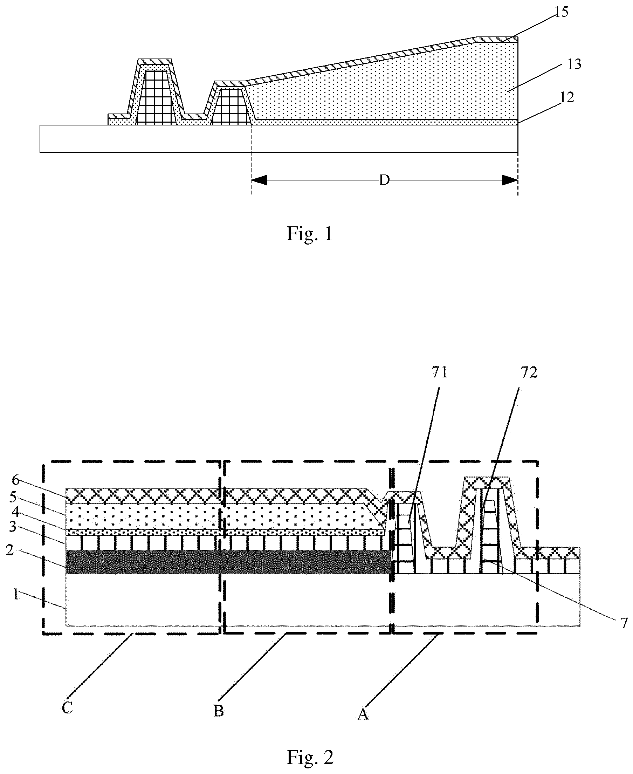

The package film layer may be a laminated structure of an inorganic film / an organic film / an inorganic film. The inorganic film may be made by various common film forming methods. Alternatively, the film is formed by CVD (Chemical Vapor Deposition) process, and the inorganic film (silicon nitride layer or silicon oxynitride layer) formed by CVD process has strong water-oxygen barrier capacity, good light transmittance and good wear resistance. Among silicon nitride (for example, SiNx) and silicon oxynitride (for example, SiON), silicon nitride has a better water-oxygen barrier capacity, but has a relatively poor adhesion to the material of the organic film; while silicon oxynitride has a relatively poor water-oxygen barrier capacity, but has a better adhesion to the material of the organic film and allows the organic ink to have a better fluidity. If a silicon nitride layer / organic film / silicon nitride layer is used as the package film layer, the uniformity of the organic film will be relatively poor, because the rheological organic material has a relatively poor leveling diffusion property on the surface of silicon nitride layer. As shown in Fig. 1, if the silicon oxynitride layer 12 / organic film 13 / silicon nitride layer 15 is used as the package film layer, the water-oxygen barrier capacity of the entire package film layer is relatively poor, because the silicon oxynitride layer 12 has a relatively poor water-oxygen barrier capacity; and, the climbing distance D of the organic film 13 is relatively large, which is not conducive to achieving a narrow bezel of the display device, because the rheological organic material has a relatively good leveling diffusion property on the surface of silicon nitride layer. To sum up, the above-mentioned package film layer cannot concern both the high water-oxygen barrier capacity and the uniformity of the organic film.

In order to solve the above technical problems, embodiments of the present disclosure provide a display panel and a display device comprising the display panel, which are capable of concerning both the high water-oxygen barrier capacity and the uniformity of the organic film.

An embodiment of the present disclosure provides a display panel, as shown in Fig. 2, comprising a display substrate and at least one package film layer covering the display substrate, the package film layer comprising a first inorganic film 3, a second inorganic film 4, an organic film 5 and a third inorganic film 6 laminated on the display substrate in sequence, wherein an adhesion between a material of the first inorganic film 3 to a material of the organic film 5 is less than an adhesion between a material of the second inorganic film 4 to a material of the organic film 5.

In the present embodiment, since the adhesion between the material of the first inorganic film and the material of the organic film is less than the adhesion between the material of the second inorganic film and the material of the organic film, when the rheological organic material is formed on the second inorganic film, the rheological organic material has a relatively good leveling diffusion property on the surface of the second inorganic film, thereby being capable of forming an organic film having relatively good uniformity. Moreover, since the adhesion between the material of the first inorganic film and the material of the organic film is relatively weak, it is ensured that the package film layer has a relatively good water-oxygen barrier capacity.

As shown in Fig. 2, the display panel comrpises a display region C and a non-display region, the non-display region including a first region A provided for a barrier structure and a second region B between the display region and the barrier structure. In the second region B, a device layer 2 on the base substrate 1 is provided. The device layer 2 may, for example, comprises an anode layer and a cathode layer. In the non-display region, the first inorganic film 3 covers the second region B and the barrier structure, and the second inorganic film 4 and the organic film 5 only cover the second region B but not cover the barrier structure. Since the first inorganic film 3 covers the second region B and the barrier structure, and the second inorganic film 4 and the organic film 5 cover the second region B but not covers the barrier structure, when the rheological organic material is leveled on the surface of the second inorganic film 4 and diffuses to the barrier structure, it is possible to prevent the rheological organic material from diffusing to the barrier structure, and confines the organic film 5 to the range defined by the barrier structure. This is because the adhesion between the material of the first inorganic film 3 covering the barrier structure and the material of the organic film 5 is relatively weak. Therefore, the rheological organic material, before passing over the barrier structure, solidifies to form the organic film 5, which contributes to realizing a narrow bezel of the display device.

In some embodiments, the constituent materials of the third inorganic film 6 and the first inorganic film 3 may be the same. That is, an adhesion between a material of the third inorganic film 6 to a material of the organic film 5 is less than an adhesion between a material of the second inorganic film 4 to a material of the organic film 5, or relatively weak.

Alternatively, as shown in Fig. 2, the third inorganic film 6 covers the second region B and the barrier structure. Since the adhesion between the material of the third inorganic film 6 to the material of the organic film 5 is relatively weak, and the inorganic film has a stronger water-oxygen barrier capacity compared with the organic film, the third inorganic film 6 covers the second region B and the barrier structure, which contributes to ensuring the water-oxygen barrier capacity of the package film layer.

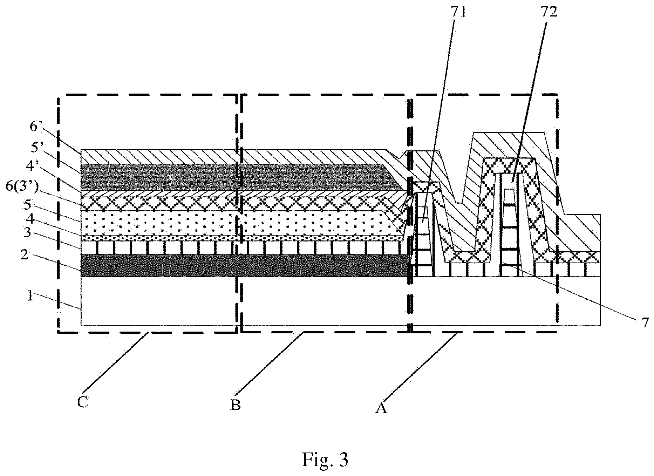

Alternatively, when the at least one package film layer comprises a first package film layer and a second package film layer laminated in sequence, the third inorganic film 6 of the first package film layer is reused as the first inorganic film 3 of the second package film layer. As shown in Fig. 3, the first package film layer comprises a first inorganic film 3, a second inorganic film 4, an organic film 5, and a third inorganic film 6; and the second package film layer comprises a first inorganic film 3', and a second inorganic film 4', an organic film 5', and an third inorganic film 6', wherein the third inorganic film 6 of the first package film is reused as the first inorganic film 3' of the second package film layer, that is, the third inorganic film 6 is the same as the first inorganic film 3'. The package structure can minimize the thickness of the package film layer.

Alternatively, the first inorganic film 3 has a thickness of 500 nm to 1000 nm, the second inorganic film 4 has a thickness of 50 nm to 100 nm, and the third inorganic film 6 has a thickness of 500 nm to 1000 nm.

In an alternative embodiment, the first inorganic film 3 is made of silicon nitride, the second inorganic film 4 is made of silicon oxynitride, and the third inorganic film 6 is made of silicon nitride, that is, the package film layer has a structure of a silicon nitride film / a silicon oxynitride film / an organic film 5 / a silicon nitride film. The two layers of silicon nitride film are manufactured by process parameters with a high water resistance, and have a thickness of about 500 nm to 1000 nm; and the silicon oxynitride film is manufactured by process parameters with a good diffusion capacity, and has a thickness of about 50 nm to 100 nm. When the above parameters are used, the thickness of the package film layer can be relatively small, and the package film layer can have a relatively good water-oxygen barrier capacity.

In the package film layer, the adhesion between the silicon nitride film and the organic film 5 is relatively poor, and the adhesion between the silicon oxynitride film and the organic film 5 is relatively good. As shown in Fig. 2, the edge of the silicon oxynitride film is closely contact with the inside of the barrier 7 proximate to the display region, and the edge of the two silicon nitride films are designed to be outside of the barrier 7 in the outermost side. When the rheological organic material flows to the inside of the barrier 7 proximate to the display region, the rheological organic material will maintain good diffusibility and uniformity due to the effect of the silicon oxynitride film. When the rheological organic material is close to the barrier 7 proximate to the display region, due to the effect of the silicon nitride film, the climbing distance of the organic film 5 can be reduced, and finally the overall water-oxygen barrier capacity of the package film layer can be improved and the climb distance of the organic film can be reduced.

As shown in Fig. 2, the barrier structure comprises at least a first barrier 71 and a second barrier 72 separated by a predetermined distance, the distance between the first barrier 71 and the display region is less than a distance between the second barrier 72 and the display region, and a height of the first barrier 71 is less than a height of the second barrier 72. The first barrier 71 and the second barrier 72 are capable of forming a stepped structure, which better presents the rheological organic material from crossing the barrier structure.

Alternatively, the display substrate is an OLED display substrate. The technical solution of the embodiment allows the OLED display panel to have a relatively good water-oxygen barrier capacity, and a relatively good uniformity of the organic film.

An embodiment of the present disclosure further provides a display device comprising the display panel as described above. The display device may be any product or component having a display function, such as a television, a display, a digital photo frame, a mobile phone, a tablet computer, etc. The display device further comprises a flexible circuit board, a printed circuit board, and a backplane.

The display device of the embodiment has a relatively good water-oxygen barrier capacity and a relatively good uniformity of the organic film, thereby ensuring the service life of the display device. In addition, the climbing distance of the organic film 5 is relatively short, so that the design distance between the edge of the display region and the barrier structure can be reduced, that is, the width of the second region B can be designed to be narrower, which contributes to a narrow bezel of the display device.

An embodiment of the present disclosure further provides a method for packaging a display panel, comprising forming at least one package film layer on a display substrate for covering the display substrate, wherein the step of forming the package film layer comprises:
laminating a first inorganic film 3, a second inorganic film 4, an organic film 5 and a first inorganic film 3 on the display substrate in sequence, wherein an adhesion between a material of the first inorganic film 3 to a material of the organic film 5 is less than an adhesion between a material of the second inorganic film 4 to a material of the organic film 5.

In the present embodiment, since the adhesion between the material of the first inorganic film and the material of the organic film is less than the adhesion between the material of the second inorganic film and the material of the organic film, when the rheological organic material is formed on the second inorganic film, it is capable of forming an organic film having relatively good uniformity. This is because the rheological diffusion property of the rheological organic material on the surface of the second inorganic film is relatively good. Moreover, since the adhesion between the material of the first inorganic film and the material of the organic film is relatively weak, it is ensured that the package film layer has a relatively good water-oxygen barrier capacity.

The display panel comprises a display region and a non-display region, as shown in Fig. 2, the non-display region comprising a first region A provided with a barrier structure and a second region B between the display region and the first region A. The method for packaging comprises:
forming a first inorganic film 3 covering the second region B and the barrier structure;
forming a second inorganic film 4 covering the second region B but not covering the barrier structure; and
covering the second inorganic film 4 with a rheological organic material, wherein the rheological organic material is blocked on a surface of the second inorganic film 4 by the barrier structure and leveled to form the organic film 5, and the organic film 5 only covers the second region B but not covers the barrier structure.

Alternatively, the rheological organic material may be printed on the second inorganic film 4.

When the rheological organic material is leveled on the surface of the second inorganic film 4 and diffuses to the barrier structure, since the adhesion between the material of the first inorganic film 3 covering the barrier structure and the material of the organic film 5 is relatively weak, it is possible to prevent the rheological organic material from diffusing to the barrier structure, thereby confining the organic film 5 to the range defined by the barrier structure. This contribute to solidifying the rheological organic material, before passing over the barrier structure, to form the organic film 5, which contributes to realizing a narrow bezel of the display device.

When the display substrate of the embodiment is an OLED display substrate, the method for packaging the display panel of the embodiment specifically comprises the following steps:
1. After the OLED display substrate is manufactured, a silicon nitride film covering a display region of an OLED display substrate, a second region B and a barrier structure and having a thickness of about 500 nm to 1000 nm is manufactured by CVD process, wherein the edge of the silicon nitride film is located outside of the barrier 7 proximate to the edge of the substrate;
2. A silicon oxynitride film having a thickness of about 50 nm to 100 nm is manufactured by CVD process, wherein the silicon oxynitride film covers a display region of the OLED display substrate and the second region B but not cover the barrier structure, and the edge of the silicon oxynitride film is in closely contact with the inside of the barrier 7 proximate to the display region;
3. An organic film 5 is manufactured by an ink-jet printing (IJP) process, wherein the organic film 5 covers the display region of the OLED display substrate and the second region B but not cover the barrier structure, and the edge of the organic film 5 is in closely contact with the inside of the barrier 7 proximate to the display region; and
4. A silicon nitride film covering a display region of an OLED display substrate, a second region B and a barrier structure and having a thickness of about 500 nm to 1000 nm is manufactured by CVD process, wherein the edge of the silicon nitride film is located outside of the barrier 7 proximate to the edge of the substrate.

The package structure can be manufactured through the above steps 1 to 4. In the embodiment, each of the package film layers comprises a silicon nitride film, a silicon oxynitride film, an organic film, and a silicon nitride film laminated in sequence. Since the adhesion between the silicon nitride film and the organic film is relatively weak and the adhesion between the silicon oxynitride film and the organic film is relatively good, when the rheological organic material is printed on the silicon oxynitride film, the rheological organic material has a relatively good leveling diffusion property on the surface of the silicon oxynitride film, thereby forming an organic film with a relatively good uniformity. Since the adhesion between the silicon nitride film and the organic film is relatively weak and the silicon nitride film has a relatively good water-oxygen barrier capacity, the package film layer can ensure a relatively good water-oxygen barrier capacity.

Unless otherwise defined, technical terms or scientific terms used herein have the normal meaning commonly understood by one skilled in the art in the field of the present disclosure. The words "first", "second", and the like used in the present disclosure does not denote any order, quantity, or importance, but rather merely serves to distinguish different components. The "including", "comprising", and the like used in the present disclosure means that the element or item appeared in front of the word encompasses the element or item and their equivalents listed after the word, and does exclude other elements or items. The word "connected" or "connecting" and the like are not limited to physical or mechanical connections, but may include electrical connections, whether direct or indirect. "On", "under", "left", "right" and the like are only used to represent relative positional relationships, and when the absolute position of the described object is changed, the relative positional relationship may also be changed, accordingly.

It will be understood that when an element, such as a layer, film, region, or substrate, is referred to as being "on" or "under" another element, the element may be directly "on" or "under" another element, or there may be an intermediate element.

The above descriptions are alternative embodiments of the present disclosure. It should be noted that one skilled in the art would make some improvements and substitutions without departing from the scope of the present invention as defined by the appended claims.

## Claims

1. A display panel comprising a display substrate (1) and at least one package film layer covering the display substrate, wherein the package film layer comprises a first inorganic film (3), a second inorganic film (4), an organic film (5) and a third inorganic film (6) laminated on the display substrate in sequence, and an adhesion between a material of the first inorganic film (3) and a material of the organic film (5) is less than an adhesion between a material of the second inorganic film (4) and a material of the organic film (5),
wherein the display panel comprises a display region (C) and a non-display region, the non-display region comprises a first region (A) provided with a barrier structure and a second region (B) between the display region (C) and the barrier structure,
wherein the barrier structure comprises at least a first barrier (71) and a second barrier (72), a distance between the first barrier and the display region is less than a distance between the second barrier and the display region, and a height of the first barrier is less than a height of the second barrier such that the first barrier and the second barrier form a stepped structure to prevent organic film from crossing the barrier structure,
wherein the first inorganic film (3) covers the second region (B) and the first barrier (71) and the second barrier (72), and the second inorganic film (4) and the organic film (5) cover the second region (B) but do not cover a top surface of the first barrier (71) and do not cover a top surface of the second barrier (72),
wherein an edge of the second inorganic film is in contact with a side surface of the first barrier covered by the first inorganic film, and the organic layer extends to the side surface of first barrier covered by the first inorganic film, the side surface being proximate to the display region.

2. The display panel of claim 1, wherein the third inorganic film (6) covers the second region (B) and the barrier structure.

3. The display panel of claim 1, wherein the third inorganic film (6) and the first inorganic film (3) are made of a same material.

4. The display panel of claim 1, wherein the at least one package film layer comprises two package film layers.

5. The display panel of claim 4, wherein the two package film layers comprise a first package film layer and a second package film layer, the third inorganic film (6) of the first package film layer is reused as the first inorganic film (3') of the second package film layer.

6. The display panel of claim 1, wherein the first inorganic film (3) is made of silicon nitride, the second inorganic film (4) is made of silicon oxynitride, and the third inorganic film (6) is made of silicon nitride.

7. The display panel of claim 6, wherein the first inorganic film (3) has a thickness of 500 nm to 1000 nm, the second inorganic film (4) has a thickness of 50 nm to 100 nm, and the third inorganic film (6) has a thickness of 500 nm to 1000 nm.

8. The display panel of any one of claims 1 to 7, wherein the display substrate is an Organic Light-Emitting Diode (OLED) display substrate.

9. A display device, comprising the display panel of any one of claims 1 to 8.

10. A method for packaging a display panel, comprising forming at least one package film layer on a display substrate for covering the display substrate,
wherein the step of forming the package film layer comprises:
laminating a first inorganic film (3), a second inorganic film (4), an organic film (5) and a third inorganic film (6) on the display substrate in sequence, wherein an adhesion between a material of the first inorganic film (3) and a material of the organic film (5) is less than an adhesion between a material of the second inorganic film (4) and a material of the organic film (5),
wherein the display panel comprises a display region (C) and a non-display region, the non-display region comprises a first region (A) provided with a barrier structure and a second region (B) between the display region (C) and the barrier structure,
wherein the barrier structure comprises at least a first barrier (71) and a second barrier (72), a distance between the first barrier and the display region is less than a distance between the second barrier and the display region, and a height of the first barrier is less than a height of the second barrier such that the first barrier and the second barrier form a stepped structure to prevent organic film from crossing the barrier structure,
wherein an edge of the second inorganic film is in contact with a side surface of the first barrier covered by the first inorganic film, and the organic layer extends to the side surface of first barrier covered by the first inorganic film, the side surface being proximate to the display region, and
wherein the method for packaging comprises:
forming the first inorganic film (3) covering the second region (B) and the first barrier (71) and the second barrier (72);
forming the second inorganic film (4) covering the second region (B) but not covering a top surface of the first barrier (71) and not covering a top surface of the second barrier (72); and
covering the second inorganic film (4) with a rheological organic material, wherein the rheological organic material is blocked on a surface of the second inorganic film (4) by the barrier structure and leveled to form the organic film (5), and the organic film (5) covers the second region (B) but does not cover the top surface of the first barrier (71) and does not cover the top surface of the second barrier (72).

## Patentansprüche

1. Anzeigetafel, umfassend ein Anzeigesubstrat (1) und mindestens eine Verpackungsfolienschicht umfasst, die das Anzeigesubstrat bedeckt, wobei die Verpackungsfolienschicht eine erste anorganische Folie (3), eine zweite anorganische Folie (4), eine organische Folie (5) und eine dritte anorganische Folie (6) umfasst, die nacheinander auf das Anzeigesubstrat laminiert sind, und eine Haftung zwischen einem Material der ersten anorganischen Folie (3) und einem Material der organischen Folie (5) geringer ist als eine Haftung zwischen einem Material der zweiten anorganischen Folie (4) und einem Material der organischen Folie (5),
wobei die Anzeigetafel einen Anzeigebereich (C) und einen Nicht-Anzeigebereich umfasst, wobei der Nicht-Anzeigebereich einen ersten Bereich (A), der mit einer Barrierestruktur versehen ist, und einen zweiten Bereich (B) zwischen dem Anzeigebereich (C) und der Barrierestruktur umfasst,
wobei die Barrierestruktur mindestens eine erste Barriere (71) und eine zweite Barriere (72) umfasst, ein Abstand zwischen der ersten Barriere und dem Anzeigebereich geringer ist als ein Abstand zwischen der zweiten Barriere und dem Anzeigebereich und eine Höhe der ersten Barriere geringer ist als eine Höhe der zweiten Barriere, so dass die erste Barriere und die zweite Barriere eine gestufte Struktur bilden, um zu verhindern, dass eine organische Folie die Barrierestruktur passiert,
wobei die erste anorganische Folie (3) den zweiten Bereich (B) und die erste Barriere (71) und die zweite Barriere (72) bedeckt und die zweite anorganische Folie (4) und die organische Folie (5) den zweiten Bereich (B) bedecken, aber keine obere Fläche der ersten Barriere (71) und keine obere Fläche der zweiten Barriere (72) bedecken,
wobei ein Rand der zweiten anorganischen Folie in Kontakt mit einer Seitenfläche der ersten Barriere steht, die von der ersten anorganischen Folie bedeckt ist, und die organische Schicht sich bis zu der Seitenfläche der ersten Barriere erstreckt, die von der ersten anorganischen Folie bedeckt ist, wobei die Seitenfläche sich in der Nähe des Anzeigebereichs befindet.

2. Anzeigetafel nach Anspruch 1, wobei die dritte anorganische Schicht (6) den zweiten Bereich (B) und die Barrierestruktur bedeckt.

3. Anzeigetafel nach Anspruch 1, wobei die dritte anorganische Folie (6) und die erste anorganische Folie (3) aus einem gleichen Material hergestellt sind.

4. Anzeigetafel nach Anspruch 1, wobei die mindestens eine Verpackungsfolienschicht zwei Verpackungsfolienschichten umfasst.

5. Anzeigetafel nach Anspruch 4, wobei die zwei Verpackungsfolienschichten eine erste Verpackungsfolienschicht und eine zweite Verpackungsfolienschicht umfassen, wobei die dritte anorganische Folie (6) der ersten Verpackungsfolienschicht als die erste anorganische Folie (3') der zweiten Verpackungsfolienschicht wiederverwendet wird.

6. Anzeigetafel nach Anspruch 1, wobei die erste anorganische Folie (3) aus Siliciumnitrid ist, die zweite anorganische Folie (4) aus Siliciumoxynitrid ist und die dritte anorganische Folie (6) aus Siliciumnitrid ist.

7. Anzeigetafel nach Anspruch 6, wobei die erste anorganische Folie (3) eine Dicke von 500 nm bis 1000 nm aufweist, die zweite anorganische Folie (4) eine Dicke von 50 nm bis 100 nm aufweist und die dritte anorganische Folie (6) eine Dicke von 500 nm bis 1000 nm aufweist.

8. Anzeigetafel nach einem der Ansprüche 1 bis 7, wobei das Anzeigesubstrat ein Anzeigesubstrat mit organischen Leuchtdioden (OLED) ist.

9. Anzeigevorrichtung, umfassend die Anzeigetafel nach einem der Ansprüche 1 bis 8.

10. Verfahren zum Verpacken einer Anzeigetafel, umfassend das Bilden mindestens einer Verpackungsfolienschicht auf einem Anzeigesubstrat zum Bedecken des Anzeigesubstrats, wobei der Schritt des Bildens der Verpackungsfolienschicht umfasst:
Laminieren einer ersten anorganischen Folie (3), einer zweiten anorganischen Folie (4), einer organischen Folie (5) und einer dritten anorganischen Folie (6) nacheinander auf das Anzeigesubstrat, wobei eine Haftung zwischen einem Material der ersten anorganischen Folie (3) und einem Material der organischen Folie (5) geringer ist als eine Haftung zwischen einem Material der zweiten anorganischen Folie (4) und einem Material der organischen Folie (5),
wobei die Anzeigetafel einen Anzeigebereich (C) und einen Nicht-Anzeigebereich umfasst, wobei der Nicht-Anzeigebereich einen ersten Bereich (A), der mit einer Barrierestruktur versehen ist, und einen zweiten Bereich (B) zwischen dem Anzeigebereich (C) und der Barrierestruktur umfasst,
wobei die Barrierestruktur mindestens eine erste Barriere (71) und eine zweite Barriere (72) umfasst, ein Abstand zwischen der ersten Barriere und dem Anzeigebereich geringer ist als ein Abstand zwischen der zweiten Barriere und dem Anzeigebereich und eine Höhe der ersten Barriere geringer ist als eine Höhe der zweiten Barriere, so dass die erste Barriere und die zweite Barriere eine gestufte Struktur bilden, um zu verhindern, dass eine organische Folie die Barrierestruktur passiert,
wobei ein Rand der zweiten anorganischen Folie in Kontakt mit einer Seitenfläche der ersten Barriere steht, die von der ersten anorganischen Folie bedeckt ist, und die organische Schicht sich bis zu der Seitenfläche der ersten Barriere erstreckt, die von der ersten anorganischen Folie bedeckt ist, wobei die Seitenfläche sich in der Nähe des Anzeigebereichs befindet, und wobei das Verfahren zum Verpacken umfasst:
Bilden der ersten anorganischen Folie (3), die den zweiten Bereich (B) und die erste Barriere (71) und die zweite Barriere (72) bedeckt;
Bilden der zweiten anorganischen Folie (4), die den zweiten Bereich (B) bedeckt, aber eine obere Fläche der ersten Barriere (71) und eine obere Fläche der zweiten Barriere (72) nicht bedeckt; und
Bedecken der zweiten anorganischen Folie (4) mit einem rheologischen organischen Material, wobei das rheologische organische Material auf einer Fläche der zweiten anorganischen Folie (4) durch die Barrierestruktur blockiert und nivelliert wird, um die organische Folie (5) zu bilden, und die organische Folie (5) den zweiten Bereich (B) bedeckt, aber nicht die obere Fläche der ersten Barriere (71) bedeckt und nicht die obere Fläche der zweiten Barriere (72) bedeckt.

## Revendications

1. Panneau d'affichage comprenant un substrat d'affichage (1) et au moins une couche de film d'encapsulation recouvrant le substrat d'affichage, dans lequel la couche de film d'encapsulation comprend un premier film inorganique (3), un deuxième film inorganique (4), un film organique (5) et un troisième film inorganique (6) stratifiés sur le substrat d'affichage les uns après les autres, et une adhérence entre une matière du premier film inorganique (3) et une matière du film organique (5) est inférieure à une adhérence entre une matière du deuxième film organique (4) et une matière du film organique (5),
dans lequel le panneau d'affichage comprend une zone d'affichage (C) et une zone de non-affichage, la zone de non-affichage comprend une première zone (A) pourvue d'une structure de barrière et une seconde zone (B) entre la zone d'affichage (C) et la structure de barrière,
dans lequel la structure de barrière comprend au moins une première barrière (71) et une seconde barrière (72), une distance entre la première barrière et la zone d'affichage est inférieure à une distance entre la seconde barrière et la zone d'affichage, et une hauteur de la première barrière est inférieure à une hauteur de la seconde barrière de telle sorte que la première barrière et la seconde barrière forment une structure étagée pour empêcher le film organique de traverser la structure de barrière,
dans lequel le premier film inorganique (3) recouvre la seconde zone (B) et la première barrière (71) et la seconde barrière (72), et le deuxième film inorganique (4) et le film organique (5) recouvrent la seconde zone (B) mais ne recouvrent pas une surface supérieure de la première barrière (71) et ne recouvrent pas une surface supérieure de la seconde barrière (72),
dans lequel un bord du deuxième film inorganique est en contact avec une surface latérale de la première barrière recouverte du premier film inorganique, et la couche organique s'étend jusqu'à la surface latérale de la première barrière recouverte du premier film inorganique, la surface latérale étant près de la zone d'affichage.

2. Panneau d'affichage selon la revendication 1, dans lequel le troisième film inorganique (6) recouvre la seconde zone (B) et la structure de barrière.

3. Panneau d'affichage selon la revendication 1, dans lequel le troisième film inorganique (6) et le premier film inorganique (3) sont constitués d'une même matière.

4. Panneau d'affichage selon la revendication 1, dans lequel la au moins une couche de film d'encapsulation comprend deux couches de film d'encapsulation.

5. Panneau d'affichage selon la revendication 4, dans lequel les deux couches de film d'encapsulation comprennent une première couche de film d'encapsulation et une seconde couche de film d'encapsulation, le troisième film inorganique (6) de la première couche de film d'encapsulation étant réutilisé en tant que premier film inorganique (3') de la seconde couche de film d'encapsulation.

6. Panneau d'affichage selon la revendication 1, dans lequel le premier film inorganique (3) est constitué de nitrure de silicium, le deuxième film inorganique (4) est constitué d'oxynitrure de silicium, et le troisième film inorganique (6) est constitué de nitrure de silicium.

7. Panneau d'affichage selon la revendication 6, dans lequel le premier film inorganique (3) a une épaisseur de 500 nm à 1 000 nm, le deuxième film inorganique (4) a une épaisseur de 50 nm à 100 nm, et le troisième film inorganique (6) a une épaisseur de 500 nm à 1 000 nm.

8. Panneau d'affichage selon l'une quelconque des revendications 1 à 7, dans lequel le substrat d'affichage est un substrat d'affichage à diodes électroluminescentes organiques (OLED).

9. Dispositif d'affichage, comprenant le panneau d'affichage selon l'une quelconque des revendications 1 à 8.

10. Procédé d'encapsulation d'un panneau d'affichage, comprenant la formation d'au moins une couche de film d'encapsulation sur un substrat d'affichage pour recouvrir le substrat d'affichage,
dans lequel l'étape de formation de la couche de film d'encapsulation comprend de :
stratifier un premier film inorganique (3), un deuxième film inorganique (4), un film organique (5) et un troisième film inorganique (6) sur le substrat d'affichage les uns après les autres, dans lequel une adhérence entre une matière du premier film inorganique (3) et une matière du film organique (5) est inférieure à une adhérence entre une matière du deuxième film inorganique (4) et une matière du film organique (5), dans lequel le panneau d'affichage comprend une zone d'affichage (C) et une zone de non-affichage, la zone de non-affichage comprend une première zone (A) pourvue d'une structure de barrière et une seconde zone (B) entre la zone d'affichage (C) et la structure de barrière,
dans lequel la structure de barrière comprend au moins une première barrière (71) et une seconde barrière (72), une distance entre la première barrière et la zone d'affichage est inférieure à une distance entre la seconde barrière et la zone d'affichage, et une hauteur de la première barrière est inférieure à une hauteur de la seconde barrière de telle sorte que la première barrière et la seconde barrière forment une structure étagée pour empêcher le film organique de traverser la structure de barrière,
dans lequel un bord du deuxième film inorganique est en contact avec une surface latérale de la première barrière recouverte du premier film inorganique, et la couche organique s'étend jusqu'à la surface latérale de la première barrière recouverte du premier film inorganique, la surface latérale étant près de la zone d'affichage, et dans lequel le procédé d'encapsulation comprend de :
former le premier film inorganique (3) recouvrant la seconde zone (B) et la première barrière (71) et la seconde barrière (72) ;
former le deuxième film inorganique (4) recouvrant la seconde zone (B) mais ne recouvrant pas une surface supérieure de la première barrière (71) et ne recouvrant pas une surface supérieure de la seconde barrière (72) ; et
recouvrir le deuxième film inorganique (4) avec une matière organique rhéologique, dans lequel la matière organique rhéologique est bloquée sur une surface du deuxième film inorganique (4) par la structure de barrière et nivelée pour former le film organique (5), et le film organique (5) recouvre la seconde région (B) mais ne recouvre pas la surface supérieure de la première barrière (71) et ne recouvre pas la surface supérieure de la seconde barrière (72).
